# EUROPÄISCHE PATENTANMELDUNG

(11) **EP 2 386 922 A2**
(43) Veröffentlichungstag der Anmeldung: **16.11.2011**
(21) Anmeldenummer: 10180518.2
(22) Anmeldetag: 28.09.2010
(51) Int. Cl.: G05B 23/02, G05B 9/02, G01R 31/28

(54) **Elektrische Schaltung**

(30) Priorität: 14.10.2009 DE 102009049336
(71) Anmelder: Robert Bosch GmbH, 70442 Stuttgart (DE)
(72) Erfinder: Da Silva, Nuno André Vaz Moreira, 4425-188, Aguas-Santas (PT); Vieira, Ricardo, 4520-625, S. Joao de Ver (PT)

(57) **Zusammenfassung**

Die Erfindung betrifft ein Verfahren zum Betreiben eines Elektrogerätes sowie eine elektrische Schaltung für ein Elektrogerät, wobei das Gerät über die elektrische Schaltung an eine externe Spannungsversorgung angeschlossen und mit Energie versorgt ist und die elektrische Schaltung eine Treiberschaltung zum Steuern oder Regeln des Gerätes umfasst.

Der Erfindung liegt die Aufgabe zugrunde, ein Verfahren zum Betreiben eines Elektrogerätes sowie eine elektrische Schaltung für einen Anschluss des Elektrogerätes zu schaffen, die eine einfache Überwachung des ordnungsgemäßen Zustandes des Elektrogerätes und der elektrischen Verbindung des Elektrogerätes mit der Spannungsversorgung erlauben.

Das erfindungsgemäße Verfahren ist gekennzeichnet durch einen Testzyklus zur Zustandsüberwachung des angeschlossenen Elektrogerätes und der Verbindung des Elektrogerätes mit der Spannungsversorgung, wobei der Testzyklus die Schritte Ausschalten des Elektrogerätes, Laden eines elektrischen Energiespeichers, Unterbrechen der Verbindung zwischen Elektrogerät und externer Spannungsversorgung, Einschalten des Elektrogerätes, Messen des Spannungsabfalls am Energiespeicher, Vergleichen mit mindestens einem Grenzwert und/oder Referenzwert, Analysieren des Zustands des Elektrogerätes und Warnmeldung, wenn der erkannte Zustand nicht tolerierbar ist. Die erfindungsgemäße Schaltung weist Mittel zur Durchführung des Verfahrens auf.

## Beschreibung

Die Erfindung betrifft ein Verfahren zum Betreiben eines Strom verbrauchenden Elektrogerätes nach dem Oberbegriff des Patentanspruches 1, sowie eine elektrische Schaltung für ein Strom verbrauchendes Elektrogerät nach dem Oberbegriff des Patentanspruches 7, wobei das Gerät über die elektrische Schaltung an eine externe Spannungsversorgung angeschlossen und mit Energie versorgt ist und die elektrische Schaltung eine Treiberschaltung zum Steuern oder Regeln des Gerätes umfasst.

Betroffene Elektrogeräte können prinzipiell alle elektrischen Verbraucher wie Geräte, Maschinen und Apparate sein, die über eine Treiberschaltung gesteuert oder geregelt werden. Die Treiberschaltung ist dabei die Instanz, die das Elektrogerät ein- und ausschaltet und gegebenenfalls einen Betriebsmodus vorgibt. Das geschieht beispielsweise mittels Durchschalten der Spannung und Freigeben eines Stromflusses bis zum Elektrogerät. Hierbei ist es für einen Nutzer von großem Interesse, über den Zustand des angeschlossenen Elektrogerätes und der elektrischen Verbindung des Elektrogerätes mit der Treiberschaltung bzw. der Spannungsversorgung Bescheid zu wissen. Denn nur wenn der Verbraucher sich in ordnungsgemäßem Zustand befindet und auch korrekt an die Spannungsversorgung angeschlossen ist, kann er auch korrekt die Befehle der Treiberschaltung empfangen und die entsprechenden Aktionen ausführen. Gründe für einen Ausfall der Elektrogeräte können beispielsweise durch Nutzung, Verschleiß oder Alterung gebrochene Kabel oder falsche bzw. fehlerhafte Verbindungen (sogenannte "kalte Lötstellen" u.ä.) sein.

Der am weitesten verbreitete Anwendungsfall in diesem Zusammenhang ist der der fehlenden Rückkopplung seitens des Verbrauchers bzw. seitens der elektrischen Schaltung oder der Treiberschaltung und der damit fehlenden Gewissheit, ob ein Ansteuerungsbefehl der Treiberschaltung beim Elektrogerät korrekt ankommt und umgesetzt wird (umgesetzt werden kann). Dies kann beispielsweise Küchengeräte, Haushaltsmaschinen, einfache Heizgeräte, Radioempfänger, Beleuchtung, usw. betreffen. Hierbei erfolgt wegen der einfachen Anwendung keine Informierung des Nutzers über den ausbleibenden Effekt. Zum Beispiel kann der Nutzer des Elektrogerätes selbst die Kontrollinstanz darstellen, die überprüft, ob das Elektrogerät ordnungsgemäß funktioniert.

Einen anderen Anwendungsfall stellen solche Elektrogeräte dar, bei denen der Effekt (das Ergebnis einer Aktion) mittels zusätzlicher Sensoren überwacht und zurückgemeldet wird, wie bei der Überprüfung von Hubbewegungen, Ventilstellungen, Druck- oder Temperaturänderungen usw. Hierbei kann das Ergebnis einer einem Elektrogerät befohlenen Aktion beispielsweise mit Positions-, Bewegungs-, Druck-, Temperatur- oder Helligkeitssensoren überwacht und gegebenenfalls mit einem Sollwert verglichen werden. Je nach Anwendungsfall und Vergleich erfolgt eine Korrektur des Ergebnisses oder eine Informierung des Nutzers über eine erfolgte oder nicht erfolgte Aktion bzw. ein befriedigendes oder unzulängliches Ergebnis. Die Detektion einer erfolgten Aktion bzw. eines befriedigenden Ergebnisses impliziert sogleich auch die Feststellung, dass das Elektrogerät sich in ordnungsgemäßem Zustand befindet und korrekt an die Treiberschaltung bzw. an die Spannungsversorgung angeschlossen sein muss. Diese Lösung ist gegenüber dem erstgenannten Anwendungsfall ohne Rückkopplung an den Nutzer deutlich informativer, aber wegen der zusätzlichen Sensoren und Auswerteschaltungen auch aufwendiger und damit anfälliger gegenüber Störungen.

Der Erfindung liegt die Aufgabe zugrunde, ein Verfahren zum Betreiben eines Elektrogerätes sowie eine elektrische Schaltung für einen Anschluss des Elektrogerätes zu schaffen, die eine einfache Überwachung des ordnungsgemäßen Zustandes des Elektrogerätes und der elektrischen Verbindung des Elektrogerätes mit der Spannungsversorgung erlauben.

Erfindungsgemäß wird dies durch die Gegenstände mit den Merkmalen des Patentanspruches 1 und 7 gelöst. Vorteilhafte Weiterbildungen sind den Unteransprüchen zu entnehmen.

Das erfindungsgemäße Verfahren zum Betreiben eines über eine elektrische Schaltung an eine externe Spannungsversorgung angeschlossenen und mit Energie versorgten Elektrogerätes mit einer Treiberschaltung zum Steuern oder Regeln des Elektrogerätes ist gekennzeichnet durch einen Testzyklus zur Zustandsüberwachung des angeschlossenen Elektrogerätes und der Verbindung des Elektrogerätes mit der Spannungsversorgung.

Dieser Testzyklus umfasst die Schritte
- Ansteuern der Treiberschaltung im Sinne eines Ausschaltens des Elektrogerätes,
- Laden eines elektrischen Energiespeichers mit der externen Spannungsversorgung,
- Ansteuern eines von einem Überwachungselement beherrschten Schalters im Sinne einer Unterbrechung der Verbindung zwischen dem Elektrogerät und dem elektrischen Energiespeicher auf der einen Seite und der externen Spannungsversorgung auf der anderen Seite,
- Ansteuern der Treiberschaltung im Sinne eines Einschaltens des Elektrogerätes unter Ausnutzung der internen Spannungsversorgung des Elektrogerätes durch den elektrischen Energiespeicher,
- Messen des Spannungsabfalls am elektrischen Energiespeicher mittels des Überwachungselements,
- Vergleichen des Spannungsabfalls mit mindestens einem in einem Datenspeicher abgelegten zugeordneten Grenzwert und/oder mit mindestens einem zugeordneten Referenzwert,
- Rückschließen auf den Zustand des Elektrogerätes und/oder den Zustand der Verbindung des Elektrogerätes mit der Spannungsversorgung anhand des Vergleichs, und
- Ausgeben einer Warnmeldung auf ein Ausgabeelement, wenn der analysierte Zustand nicht mit einem vorgebbaren tolerierten Zustand übereinstimmt.

Durch das Ausschalten des Elektrogerätes wird der Energieverbrauch unterbrochen, falls dies nicht sowieso der zum Auslösezeitpunkt des Testzyklus' herrschende Betriebsmodus ist. Da die elektrische Schaltung an eine externe Spannungsversorgung angeschlossen ist, lädt sich der elektrische Energiespeicher auf. Sodann wird die Verbindung zwischen Elektrogerät und elektrischem Energiespeicher einerseits und der externen Spannungsversorgung andererseits unterbrochen, sodass der elektrische Energiespeicher nun nicht mehr aufgeladen bzw. nachgeladen wird. Anschließend wird das Elektrogerät (Verbraucher) eingeschaltet. Als Energiequelle steht jetzt nur der elektrische Energiespeicher endlicher Größe zur Verfügung, der sich folglich entlädt, was sich durch einen Spannungsabfall am Energiespeicher bemerkbar macht. Dieser Spannungsabfall wird gemessen und mit zugeordneten Grenzwerten bzw. Referenzwerten verglichen. Die Grenzwerte können beispielsweise ein vom Gerätehersteller vorgegebener sehr niedriger und/oder ein sehr hoher Wert sein, die dann Hinweise auf eine fehlende Verbindung zum Elektrogerät oder auf einen Kurzschluss geben können. Ein Referenzwert kann beispielsweise ein früher gemessener Spannungsabfall sein, wie er sich unter "guten" Geräte- und Verbindungszuständen ergeben hat, oder ein vom Gerätehersteller vorgegebener "normaler" Spannungsabfall. In Abhängigkeit des Vergleichs bzw. des analysierten Zustands des Elektrogerätes und/oder des Zustands der Verbindung des Elektrogerätes mit der Spannungsversorgung wird eine Warnmeldung ausgegeben, die dem Nutzer signalisiert, dass sich das Elektrogerät oder die Verbindung zur Spannungsversorgung in einem nicht tolerierten Zustand befinden. Geeignete Ausführungen des Verfahrens sind dadurch gekennzeichnet, dass der Testzyklus manuell oder periodisch in vorgebbaren Zeitintervallen oder regelmäßig bei Vorliegen eines bestimmten Betriebsmodus' ausgelöst und durchgeführt wird. Die manuelle Variante kann durch den Nutzer oder einen Servicetechniker erfolgen und gegen unbeabsichtigtes Auslösen geschützt sein. Die periodische Variante kann zum Beispiel einmal täglich oder alle 10 Betriebsstunden erfolgen. Die am Betriebsmodus orientierte Variante kann beispielsweise bei jedem oder bei jedem hundertsten Ausschalten erfolgen.

Die Grenz- und/oder Referenzwerte sowie die Güte des Vergleichs können sehr verschieden ausgeführt sein. Bei einer einfachen Ausführung wird lediglich geprüft, ob überhaupt ein Spannungsabfall vorliegt, also ob der gemessene Spannungsabfall verschieden von Null ist. Daraus kann gefolgert werden, dass der Verbraucher angeschlossen ist.

Eine anspruchsvolle Ausführung ist dadurch gekennzeichnet, dass das Messen des Spannungsabfalls ein Erfassen eines zeitlichen Verlaufs des Spannungsabfalls umfasst, wobei aus einem Anfangsspannungswert zu einem vorgebbaren Anfangszeitpunkt und einem Endspannungswert zu einem vorgebbaren Endzeitpunkt ein durchschnittlicher Spannungsgradient ermittelt wird. Der zeitliche Verlauf des Spannungsabfalls wird mittels eines Vergleichs mit Grenzwerten und/oder Referenzwerten analysiert. Damit kann nicht nur festgestellt werden, ob der Verbraucher angeschlossen ist, sondern auch, ob die Entladungskurve des elektrischen Energiespeichers mit dem Verhalten eines Elektrogerätes in ordnungsgemäßem Zustand korrespondiert. So können beispielsweise Alterungen und/oder ein interner Kurzschluss des Elektrogerätes bzw. der Verbindung zur Spannungsversorgung erkannt werden.

Eine Ausführung ist dadurch gekennzeichnet, dass das Ausgeben einer Warnmeldung auf das Ausgabeelement erfolgt, wenn der Spannungsabfall kleiner als ein zugeordneter unterer Grenzwert oder größer als ein zugeordneter oberer Grenzwert oder deutlich verschieden von dem mindestens einen zugeordneten Referenzwert ist.

Weitere Ausführungen sind dadurch gekennzeichnet, dass das Ausgeben der Warnmeldung ein visuell oder akustisch wahrnehmbares Ausgeben umfasst, so dass die Warnung beispielsweise mittels blinkender oder verschieden farbiger Lichter oder über eine Display-Anzeige oder über einen Ton oder eine Tonfolge kenntlich gemacht wird.

Eine geeignete Ausführung ist dadurch gekennzeichnet, dass das Ausgeben der Warnmeldung verschiedene Warnstufen umfasst, die in Abhängigkeit von der Analyse ausgelöst werden. Dies können beispielsweise eine erste Warnstufe für einen ordnungsgemäßen Zustand, eine zweite Warnstufe für einen nicht mehr ordnungsgemäßen aber noch tolerierbaren Zustand (z.B. durch eingetretene Alterung einer Komponente) und/oder eine dritte Warnstufe für eine nicht mehr tolerierbare Zustandsverschlechterung oder einen Ausfall sein. Somit erhält ein Nutzer oder ein Servicetechniker mit der zweiten Warnstufe einen frühzeitigen Hinweis auf einen demnächst zu erwartenden Ausfall und kann seine Austausch- oder Wartungsarbeiten rechtzeitig planen, so dass ein überraschender Ausfall des Elektrogerätes vermieden wird.

Die erfindungsgemäße elektrische Schaltung für einen Anschluss an eine externe Spannungsversorgung und für eine Energieversorgung eines Elektrogerätes mit einer Treiberschaltung zum Steuern oder Regeln des Elektrogerätes, ist dadurch gekennzeichnet, dass die elektrische Schaltung eine Testschaltung für eine Zustandsüberwachung des angeschlossenen Elektrogerätes und der Verbindung des Elektrogerätes mit der Spannungsversorgung umfasst.

Dabei umfasst die Testschaltung folgende Mittel, wie sie zur Durchführung des vorstehend beschriebenen Verfahrens geeignet sind, nämlich:
- einen Schalter zur Unterbrechung der Verbindung zwischen dem Elektrogerät und einem elektrischen Energiespeicher auf der einen Seite und der externen Spannungsversorgung auf der anderen Seite,
- einen elektrischen Energiespeicher zur internen Spannungsversorgung des Elektrogerätes im Falle einer Unterbrechung der Verbindung zur externen Spannungsversorgung,
- ein Überwachungselement zum Überwachen und/oder Verändern des Schaltzustandes des Schalters, zum Messen eines Spannungsabfalls am elektrischen Energiespeicher, zum Vergleichen des Spannungsabfalls mit mindestens einem in einem Datenspeicher abgelegten zugeordneten Grenzwert und/oder mit mindestens einem zugeordneten Referenzwert und zum Analysieren des Zustands des Elektrogerätes und/oder des Zustands der Verbindung des Elektrogerätes mit der Spannungsversorgung anhand des Vergleichs, und
- ein Ausgabeelement zum Ausgeben einer Warnmeldung, wenn der ermittelte Zustand nicht mit einem tolerierten Zustand übereinstimmt.

Eine Ausführung der elektrischen Schaltung ist dadurch gekennzeichnet, dass die externe Spannungsversorgung eine Gleichspannungsversorgung ist.

Eine geeignete Ausführung ist dadurch gekennzeichnet, dass der Schalter ein elektronischer Schalter ist ausgewählt aus der Gruppe umfassend Transistoren, Relais, Mosfets.

Eine Ausführung ist dadurch gekennzeichnet, dass der elektrische Energiespeicher ein Kondensator ist.

Eine Ausführung ist dadurch gekennzeichnet, dass der elektrische Energiespeicher parallel zur externen Spannungsversorgung geschaltet ist.

Eine Ausführung ist dadurch gekennzeichnet, dass das Überwachungselement Mittel zum Messen des zeitlichen Verlaufs des Spannungsabfalls am elektrischen Energiespeicher aufweist.

Eine Ausführung ist dadurch gekennzeichnet, dass das Ausgabeelement zur Ausgabe einer Warnmeldung über ein oder mehrere Leuchtmittel, LCD-Displays oder akustische Signalgeber verfügt.

Mit der vorstehend offenbarten Erfindung sind ein Verfahren sowie Mittel zu seiner Durchführung geschaffen, mit denen der ordnungsgemäße Zustand eines Elektrogerätes und seiner Verbindung mit einer Spannungsversorgung überwacht werden können, ohne dass es zusätzlicher spezieller Sensoren zur Messung eines Effektes des Elektrogerätes bedarf. Die einfache und universell einsetzbare Überwachungselektronik ist in der Anschluss- bzw. Treiberschaltung des Elektrogerätes enthalten. Das Verfahren macht sich den Umstand zunutze, dass elektrische Verbraucher in ordnungsgemäßem Zustand eine bestimmte Leistungsaufnahme zeigen, die sich messbar von der Leistungsaufnahme im Störfall unterscheidet. Bei der Überwachung wird das zu überwachende Elektrogerät auf eine Energieversorgung aus einem schaltungsinternen elektrischen Energiespeicher umgeschaltet, beispielsweise ein Kondensator. Bei Einschalten des Elektrogerätes entlädt sich nun der Energiespeicher, wobei sich in Abhängigkeit der Leistungsaufnahme des Elektrogerätes sowie der Speichergröße und der Anfangsspannung des elektrischen Energiespeichers z.B. ein zeitlicher Verlauf des Spannungsabfalls am elektrischen Energiespeicher einstellt. Dabei unterscheidet sich der Spannungsabfalls bei ordnungsgemäßem Elektrogerät und ordnungsgemäßer Verbindung mit dem Energiespeicher von dem Spannungsabfall bei fehlerhaftem Elektrogerät bzw. fehlerhafter Verbindung. Aus dem Vergleich des gemessenen Spannungsverlaufs mit Grenz- oder Referenzwerten kann auf den Zustand von Elektrogerät und Verbindung geschlossen werden. Stimmt der ermittelte Zustand nicht mit einem tolerierten Zustand überein, so wird eine visuell oder akustisch wahrnehmbare Warnmeldung ausgegeben, die den Nutzer über den schadhaften Zustand des Elektrogerätes bzw. der Verbindung zur Spannungsversorgung informiert.

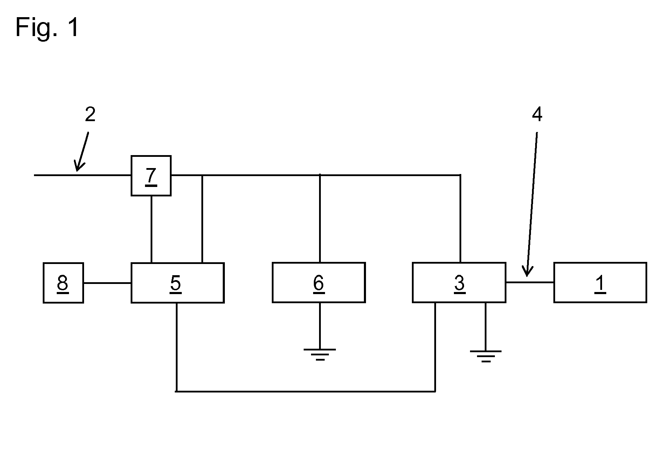

Die Zeichnung stellt ein Ausführungsbeispiel der erfindungsgemäßen elektrischen Schaltung für einen Anschluss an eine externe Spannungsversorgung und für eine Energieversorgung eines Elektrogerätes dar.

Die einzige Figur zeigt eine elektrische Schaltung mit einem Elektrogerät 1 und Anschluss an eine externe Gleichspannungsversorgung 2. Die elektrische Schaltung umfasst eine Treiberschaltung 3 zum Steuern oder Regeln des Elektrogerätes 1, wobei das Elektrogerät 1 mittels der Verbindung 4 an die Treiberschaltung 3 und damit an die Spannungsversorgung 2 angeschlossen ist. Zur Zustandsüberwachung des Elektrogerätes 1 bzw. der Verbindung 4 mit der Spannungsversorgung 2 umfasst die elektrische Schaltung eine Testschaltung mit einem Überwachungselement 5, einem elektrischen Energiespeicher 6, einem Schalter 7 sowie einem Ausgabeelement 8. Das Verfahren zum Betreiben des Elektrogerätes 1 umfasst einen Testzyklus zur Zustandsüberwachung. In diesem Testzyklus wird das Elektrogerät 1 mittels der Treiberschaltung 3 ausgeschaltet (spannungsfrei geschaltet). Durch Verbindung zur externen Spannungsversorgung 2 lädt sich der elektrische Energiespeicher 6 auf. Nun schaltet das Überwachungselement 5 den Schalter 7 um, so dass die Verbindung zwischen Elektrogerät 1, Treiberschaltung 3 und elektrischem Energiespeicher 6 einerseits und der externen Spannungsversorgung 2 andererseits unterbrochen ist. Dann schaltet die Treiberschaltung 3 das Elektrogerät 1 ein, das unter Ausnutzung der internen Spannungsversorgung durch den elektrischen Energiespeicher 6 in Betrieb geht und eine Aktion ausführt. Dabei entlädt sich der Energiespeicher 6. Das Überwachungselement 5 misst den mit dieser Entladung einhergehenden Spannungsabfall des Energiespeichers 6 und vergleicht ihn mit vorgebbaren zugeordneten Grenzwerten und/oder Referenzwerten. Basierend auf diesem Vergleich wird der Zustand des Elektrogerätes 1 bzw. der Verbindung 4 zur Spannungsversorgung 2 analysiert (Rückschluss). Ergibt die Analyse einen nicht tolerierbaren Zustand, so löst das Überwachungselement 5 eine auf dem Ausgabeelement 8 auszugebende, visuell oder akustisch wahrnehmbare Warnmeldung aus, anhand der ein Nutzer oder Servicetechniker den Zustand erkennen und Austausch- oder Wartungsarbeiten planen bzw. durchführen kann.

## Patentansprüche

1. Verfahren zum Betreiben eines über eine elektrische Schaltung an eine externe Spannungsversorgung (2) angeschlossenen und mit Energie versorgten Elektrogerätes (1) mit einer Treiberschaltung (3) zum Steuern oder Regeln des Elektrogerätes (1), **gekennzeichnet durch** einen Testzyklus zur Zustandsüberwachung des angeschlossenen Elektrogerätes (1) und der Verbindung des Elektrogerätes (1) mit der Spannungsversorgung (2), wobei der Testzyklus die Schritte umfasst
• Ansteuern der Treiberschaltung (3) im Sinne eines Ausschaltens des Elektrogerätes (1),
• Laden eines elektrischen Energiespeichers (6) mit der externen Spannungsversorgung (2),
• Ansteuern eines von einem Überwachungselement (5) beherrschten Schalters (7) im Sinne einer Unterbrechung der Verbindung zwischen dem Elektrogerät (1) und dem elektrischen Energiespeicher (6) auf der einen Seite und der externen Spannungsversorgung (2) auf der anderen Seite,
• Ansteuern der Treiberschaltung (3) im Sinne eines Einschaltens des Elektrogerätes (1) unter Ausnutzung der internen Spannungsversorgung des Elektrogerätes (1) **durch** den elektrischen Energiespeicher (6),
• Messen des Spannungsabfalls am elektrischen Energiespeicher (6) mittels des Überwachungselements (5),
• Vergleichen des Spannungsabfalls mit mindestens einem in einem Datenspeicher abgelegten zugeordneten Grenzwert und/oder mit mindestens einem zugeordneten Referenzwert,
• Analysieren des Zustands des Elektrogerätes (1) und/oder des Zustands der Verbindung (4) des Elektrogerätes (1) mit der Spannungsversorgung (2) anhand des Vergleichs, und
• Ausgeben einer Warnmeldung auf ein Ausgabeelement (8), wenn der ermittelte Zustand nicht mit einem vorgebbaren tolerierten Zustand übereinstimmt.

2. Verfahren nach Anspruch 1,
**dadurch gekennzeichnet, dass** der Testzyklus manuell oder periodisch in vorgebbaren Zeitintervallen oder regelmäßig bei Vorliegen eines bestimmten Betriebsmodus' ausgelöst und durchgeführt wird.

3. Verfahren nach Anspruch 1 oder 2,
**dadurch gekennzeichnet, dass** das Messen des Spannungsabfalls ein Erfassen eines zeitlichen Verlaufs des Spannungsabfalls umfasst, wobei aus einem Anfangsspannungswert zu einem vorgebbaren Anfangszeitpunkt und einem Endspannungswert zu einem vorgebbaren Endzeitpunkt ein durchschnittlicher Spannungsabfall ermittelt wird.

4. Verfahren nach einem der Ansprüche 1 bis 3,
**dadurch gekennzeichnet, dass** das Ausgeben einer Warnmeldung auf das Ausgabeelement (8) erfolgt, wenn der Spannungsabfall kleiner als ein zugeordneter unterer Grenzwert oder größer als ein zugeordneter oberer Grenzwert oder deutlich verschieden von dem mindestens einen zugeordneten Referenzwert ist.

5. Verfahren nach einem der Ansprüche 1 bis 4,
**dadurch gekennzeichnet, dass** das Ausgeben der Warnmeldung ein visuell und/oder akustisch wahrnehmbares Ausgeben umfasst.

6. Verfahren nach einem der Ansprüche 1 bis 5,
**dadurch gekennzeichnet, dass** das Ausgeben der Warnmeldung verschiedene Warnstufen umfasst, wie eine erste Warnstufe für einen ordnungsgemäßen Zustand und/oder eine zweite Warnstufe für einen nicht mehr ordnungsgemäßen aber noch tolerierten Zustand und/oder eine dritte Warnstufe für eine nicht mehr tolerierte Zustandsverschlechterung oder einen Ausfall, die in Abhängigkeit von der Analyse ausgelöst werden.

7. Elektrische Schaltung für einen Anschluss an eine externe Spannungsversorgung (2) und für eine Energieversorgung eines Elektrogerätes (1) mit einer Treiberschaltung (3) zum Steuern oder Regeln des Elektrogerätes (1),
**dadurch gekennzeichnet, dass** die elektrische Schaltung eine Testschaltung für eine Zustandsüberwachung des angeschlossenen Elektrogerätes (1) und der Verbindung (4) des Elektrogerätes (1) mit der Spannungsversorgung (2) umfasst mit
• einem Schalter (7) zur Unterbrechung der Verbindung zwischen dem Elektrogerät (1) und einem elektrischen Energiespeicher (6) auf der einen Seite und der externen Spannungsversorgung (2) auf der anderen Seite,
• einem elektrischen Energiespeicher (6) zur internen Spannungsversorgung des Elektrogerätes (1) im Falle einer Unterbrechung der Verbindung zur externen Spannungsversorgung (2),
• einem Überwachungselement (5) zum Überwachen und/oder Verändern des Schaltzustandes des Schalters (7), zum Messen eines Spannungsabfalls am elektrischen Energiespeicher (6), zum Vergleichen des Spannungsabfalls mit mindestens einem in einem Datenspeicher abgelegten zugeordneten Grenzwert und/oder mit mindestens einem zugeordneten Referenzwert, zum Analysieren des Zustands des Elektrogerätes (1) und/oder des Zustands der Verbindung (4) des Elektrogerätes (1) mit der Spannungsversorgung (2) anhand des Vergleichs, und
• einem Ausgabeelement (8) zum Ausgeben einer Warnmeldung, wenn der ermittelte Zustand nicht mit einem vorgebbaren tolerierten Zustand übereinstimmt.

8. Elektrische Schaltung nach Anspruch 7,
**dadurch gekennzeichnet, dass** die externe Spannungsversorgung (2) eine Gleichspannungsversorgung ist.

9. Elektrische Schaltung nach Anspruch 7 oder 8,
**dadurch gekennzeichnet, dass** der Schalter (7) ein elektronischer Schalter ist ausgewählt aus der Gruppe umfassend Transistoren, Relais, Mosfets.

10. Elektrische Schaltung nach einem der Ansprüche 7 bis 9,
**dadurch gekennzeichnet, dass** der elektrische Energiespeicher (6) ein Kondensator ist.

11. Elektrische Schaltung nach einem der Ansprüche 7 bis 10,
**dadurch gekennzeichnet, dass** der elektrische Energiespeicher (6) parallel zur externen Spannungsversorgung (2) geschaltet ist.

12. Elektrische Schaltung nach einem der Ansprüche 7 bis 11,
**dadurch gekennzeichnet, dass** das Überwachungselement (5) Mittel zum Messen des zeitlichen Verlaufs des Spannungsabfalls am elektrischen Energiespeicher (6) aufweist.

13. Elektrische Schaltung nach einem der Ansprüche 7 bis 12,
**dadurch gekennzeichnet, dass** das Ausgabeelement (8) zur Ausgabe einer Warnmeldung über ein oder mehrere Leuchtmittel oder akustische Signalgeber verfügt.
